# EUROPÄISCHE PATENTSCHRIFT

(11) **EP 3 367 116 B1**
(45) Veröffentlichungstag und Bekanntmachung des Hinweises auf die Patenterteilung: **01.01.2020**
(21) Anmeldenummer: 17158487.3
(22) Anmeldetag: 28.02.2017
(51) Int. Cl.: G01R 31/42, G01R 31/02, H02J 3/38, H02J 3/00

(54) **VERFAHREN UND VORRICHTUNG ZUR PRÜFUNG EINER STROMERZEUGUNGSEINHEIT**
METHOD AND DEVICE FOR CHECKING A POWER GENERATION DEVICE
PROCÉDÉ ET DISPOSITIF DESTINÉS À VÉRIFIER UNE UNITÉ DE PRODUCTION DE COURANT

(43) Veröffentlichungstag der Anmeldung: 29.08.2018
(73) Patentinhaber: Nordex Energy GmbH, 22419 Hamburg (DE)
(72) Erfinder: Wessels, Christian, 20357 Hamburg (DE); Müller, Andreas, 25355 Lutzhorn (DE)
(74) Vertreter: Hauck Patentanwaltspartnerschaft mbB

(56) Entgegenhaltungen:
- EP-A1- 3 043 063
- EP-B1- 2 463 674
- CA-A1- 2 949 871
- CN-A- 102 129 036
- RAINER KLOSSE ET AL: "What shall I do with a conventional UVRT Test Rig to carry out OVRT Tests and other Tests required for a full model validation", GE RENEWABLE ENERGY SEITE, Bd. 1, 1. Januar 2016 (2016-01-01), XP055402125,

## Beschreibung

Die vorliegende Erfindung betrifft ein Verfahren und eine Vorrichtung zur Prüfung einer Stromerzeugungseinheit, insbesondere einer Windenergieanlage.

In kommenden technischen Richtlinien zur Vermessung der Netzqualität (Power Quality) von Windenergieanlagen wird die Fähigkeit zum Durchfahren von transienten Überspannungen nachzuweisen sein. Das Durchfahren transienter Überspannungen wird in diesem Kontext gelegentlich auch als High Voltage Ride Through (HVRT) bezeichnet. Ein Netzanschlussrichtlinien-konformer Nachweis einer HVRT-Fähigkeit einer Windenergieanlage wird in Deutschland gemäß "TAB Hochspannung" (VDE-AR-N 4120 Anwendungsregel: T2015-01 Technische Bedingungen für den Anschluss und Betrieb von Kundenanlagen an das Hochspannungsnetz) bereits gefordert. Darin wird in Bezug auf die HVRT-Fähigkeit der Nachweis gefordert, dass ein Spannungssprung von 100% U_{N} auf einen Wert zwischen 105% U_{N} und 110% U_{N} mit einer Dauer von 500ms möglich ist.

Vorrichtungen die zur Prüfung des HVRT-Verhaltens in der Leistungsklasse von Windenergieanlagen und auf Mittelspannungsebene geeignet sind, sind in der Praxis z. Z. kaum verfügbar. Generell sind verschiedene Ansätze, um dynamische Überspannungen zur Durchführung von HVRT-Tests zu erzeugen, in der Vergangenheit vorgestellt worden.

Wessels, C. et al. "Transformer based voltage sag generator to perform LVRT and HVRT tests in the laboratory", Power Electronics and Motion Control Conference (EPE/PEMC), 2010 pp.T11-8, T11-13, 6.-8. Sept. 2010 beschreibt eine Vorrichtung, mit der transiente Überspannungen auf Niederspannungsebene erzeugt werden können. Die Vorrichtung basiert auf einem Transformator mit Wicklungsanzapfungen zwischen denen mithilfe leistungselektronischer IGBT-Schalter umgeschaltet wird. Ein Prototyp mit ca. 20 kW wurde realisiert. Eine solche Lösung ist auf Mittelspannungsebene aufgrund der nicht verfügbaren Leistungsschalter nicht ökonomisch umsetzbar.

R. Klosse "High-Voltage-Ride-Through Test System based on a Transformer Switching, Realization and Validation", Proceedings of the 12th Wind Integration Workshop, London, 2013, stellt einen Prototypen für ein Testsystem in der 10 kW-Leistungsklasse vor. Der Prototyp besitzt einen Transformator zwischen dessen Anzapfungen durch IGBT-Schalter geschaltet wird, um eine dynamische Spannung zur Erhöhung an einer Testeinheit zur erzeugen.

Aus DE 10 2008 049 629 A1 ist eine Prüfeinrichtung bekannt, bei der Spannungen durch einen Spartransformator verarbeitet werden. Der Spartransformator kann mit einem Teil der Spannung des eigenen Kerns oder mit einem Umrichter mit Spannung beaufschlagt werden.

Aus EP 2 463 674 B1 ist ein stufbarer Transformator vor eine Kurzschlusstesteinheit geschaltet. Der Transformator wird in Kombination mit einer KurzschlussTesteinheit (LVRT-Einheit) geschaltet, um den gewünschten Überspannungsverlauf zu erzeugen. Der Transformator ist über den Schalter 104 zu überbrücken und über die Schalter 105 frei zu schalten. Bei Durchführung des Tests wird der Transformator zunächst frei geschaltet, also getrennt und überbrückt. Das erforderliche Überspannungsniveau wird am Transformator eingestellt. Anschließend wird eine Unterspannung an dem LVRT erzeugt, in dem Schalter 109 geschaltet wird. Anschließend wird der Transformator durch Öffnung von Überbrückungsschalter 104 und Schließen der Schalter zur Freischaltung 105a und 105b mit der Windenergieanlage 115 verbunden. Auf diese Weise ist die Testeinrichtung vorgeladen, um durch Öffnen des Schalters 109 eine dynamische Spannungserhöhung an der Windenergieanlage zu erzeugen. Hierbei entsteht ein spezifischer Spannungsverlauf. Nachteilhaft an dem Verfahren ist, dass die Testeinheit (Windenergieanlage) während des "Vorladevorganges" ausgeschaltet sein muss, da der beschriebene Transformator nicht im Übersetzungsverhältnis unter Last verstellt werden kann. Die Einstellung des Übersetzungsverhältnisses ist nur nach Freischaltung ohne Last möglich. Durch diese Prozedur verlängern sich die Testzeiten im Feld maßgeblich.

Kurzschlusssimulatoren bzw. Kurzschlusstesteinheiten können beispielsweise nach einem Spannungsteilerprinzip arbeiten. Hierzu verfügen sie über eine Vorschlussdrossel und eine Kurzschlussdrossel. Vorschlussdrossel wird gelegentlich auch als Serienimpedanz bezeichnet, während die Kurzschlussdrossel auch als Längsimpedanz bezeichnet wird. Die Kurzschlussdrossel wird über einen Schalter aktiviert, bei dem es sich um einen mechanischen Leistungsschalter oder einen elektronischen Schalter handelt, wenn die Schalteigenschaften mit einem Mittelspannungsschalter vergleichbar sind.

Der Erfindung liegt die Aufgabe zugrunde, ein Verfahren und eine Vorrichtung zum Prüfen einer Stromerzeugungseinheit bereitzustellen, die mit möglichst einfachen Mitteln die zeitoptimierte Prüfung einer Stromerzeugungseinheit auch über einen Netzkurzschluss hinaus gestattet. Insbesondere werden Prüfungen der Stromerzeugungseinheit bei dynamischer Überspannung, stationärer Über- und Unterspannung, sowie dynamischer Unterspannung angestrebt.

Erfindungsgemäß wird die Aufgabe durch ein Verfahren mit den Merkmalen aus Anspruch 1 und eine Vorrichtung mit den Merkmalen aus Anspruch 10 gelöst. Vorteilhafte Ausgestaltungen bilden die Gegenstände der Unteransprüche.

Das erfindungsgemäße Verfahren ist vorgesehen und bestimmt zur Prüfung einer Stromerzeugungseinrichtung, insbesondere einer Windenergieanlage, die mit einem elektrischen Versorgungsnetz verbunden ist. Das Verfahren umfasst die Schritte, dass ein unter Last schaltbarer Transformator eine Spannung der Stromerzeugungsseite erhöht. Der unter Last schaltbare Transformator (on load tap changer, OLTC) ermöglicht ausgehend von einem Übersetzungsverhältnis von ungefähr 1 : 1 dieses stufenweise zu erhöhen, sodass die Spannung in der Sekundärwicklung höher als die Spannung in der Primärwicklung ist. Ferner wird eine Kurzschlusstesteinheit mit einer Serien- und einer Längsimpedanz geschaltet, um die hochgesetzte Spannung zu verringern. Die Kurzschlusstesteinheit wird geschaltet, um genau definiert die Spannung herunterzusetzen. Nach Abklingen von transienten Vorgängen wird die Kurzschlusstesteinheit für eine erste definierte Zeitspanne ausgeschaltet. Durch die Kurzschlusstesteinheit geht die Spannung an der Testeinheit (speziell Windkraftanlage) wieder auf den durch den Transformator erhöhten Wert. Nach Ablauf der ersten Zeitspanne wird die Kurzschlusstesteinheit für eine definierte zweite Zeitspanne eingeschaltet und die hochgesetzte Spannung herabgesetzt. Durch das Einschalten der Kurzschlusstesteinheit nach Ablauf einer ersten Zeitspanne definiert die Dauer der ersten Zeitspanne die Dauer, mit der die Windenergieanlage einer netzseitigen Überspannung ausgesetzt ist. Um das Verhalten der Windenergieanlage bei einer Überspannung vollständig beurteilen zu können, erfolgt die Prüfung auch in der definierten zweiten Zeitspanne in der, nach dem erhöhten Spannungswert dieser wieder herabgesetzt ist.

Der besondere Vorteil des erfindungsgemäßen Verfahrens liegt daran, dass die Stromerzeugungseinheit während der Verstellung der Spannung über den Transformator im Produktionsbetrieb verbleibt. Weder eine Trennung der Stromerzeugungseinheit noch eine Trennung des Transformators über einen BypassSchalter sind notwendig, um das erfindungsgemäße Verfahren durchzuführen.

Hierdurch verkürzt sich die gesamte Messdauer und Produktionsausfälle werden reduziert.

In einer bevorzugten Weiterbildung des Verfahrens wird wenigstens in der ersten und zweiten Zeitspanne mindestens eine elektrische Größe der Stromerzeugungseinheit gemessen. Die elektrische Größe der Stromerzeugungseinheit richtet sich nach den für den HVRT-Fall relevanten Größen.

In einer bevorzugten Weiterbildung stuft nach Ablauf der zweiten Zeitspanne der Transformator die Spannung wieder auf ein gleiches Verhältnis von ungefähr 1 : 1 herab. Durch das Wiederherstellen des gleichen Übersetzungsverhältnisses mit ungefähr 1 : 1 wird der Prüfvorgang beendet. Nach Ablauf der zweiten Zeitspanne wird ebenfalls bevorzugt die Kurzschlusstesteinheit ausgeschaltet. Auf diese Weise kehrt die Stromerzeugungseinheit wieder in den regulären Betrieb zurück.

In einer bevorzugten Ausgestaltung setzt die Kurzschlusstesteinheit die hochgesetzte Spannung auf einen an dem Transformator anliegenden Spannungswert herab. Dies bedeutet, dass die Kurzschlusstesteinheit die Spannung genau um den Betrag herabsetzt, um den der Transformator den Spannungswert heraufsetzt. Dieser Ausgleich der durch den Transformator erzeugten Wirkung bedeutet, dass ohne weitere Änderungen an dem Transformator das Verhalten bei hochgesetzter Spannung untersucht werden kann.

In einer anderen Weiterbildung setzt die Kurzschlusseinheit den Spannungswert auf einen Wert herab, der kleiner als der an dem Transformator anliegende Spannungswert ist. Um für die Messung den Ausgangswert wieder zu erzielen, setzt der Transformator anschließend die anliegende Spannung auf einen Wert hoch, der bei zugeschalteter Kurzschlusstesteinheit dem Wert der an dem Transformator anliegenden Spannung entspricht. Im Gegensatz zu der zuvor beschriebenen Variante wird hier bei zugeschalteter Kurzschlusstesteinheit das Übersetzungsverhältnis des Transformators geändert.

In einer ganz besonders bevorzugten Ausgestaltung bleibt die Stromerzeugungseinheit während ihrer Prüfung mit dem Versorgungsnetz verbunden. Es kann somit ein Betriebsausfall vermieden werden und der Test in relativ kurzer Zeit durchgeführt werden.

Bevorzugt kann die Spannung auch mittels eines zuschaltbaren Kondensators einer Überspannungstesteinheit weiter erhöht werden. Der Kondensator kann bevorzugt während eines regulären Betriebs geladen werden, um im geladenen Zustand dann für eine Spannungserhöhung zugeschaltet zu werden.

Die Erfindung wird ebenfalls durch eine Vorrichtung zum Prüfen einer mit einem elektrischen Versorgungsnetz verbundenen Stromerzeugungseinheit nach Anspruch 10 gelöst. Als Stromerzeugungseinheit ist bevorzugt eine Windenergieanlage vorgesehen. Die Vorrichtung besitzt eine zwischen die Stromerzeugungseinheit und das Versorgungsnetz schaltbare Kurzschlusstesteinheit mit einer Längs- und einer Serienimpedanz und einem zwischen Kurzschlusstesteinheit und Versorgungsnetz schaltbaren Transformator, der unter Spannung und Last stufbar geschaltet werden kann. Das Übersetzungsverhältnis des Transformators kann bei einer mehrphasigen Stromleitung in jeder Phase unabhängig gewählt werden. Ein besonderer Vorteil der erfindungsgemäßen Prüfvorrichtung ist neben den kurzen Messzeiträumen auch, dass auf eine bereits bestehende Kurzschlusstesteinheit zurückgegriffen werden kann.

In einer bevorzugten Weiterbildung ist eine Steuereinrichtung vorgesehen, die den Transformator und die Kurzschlusstesteinheit ansteuert. Die Steuereinrichtung kann hierbei auf vorhandene Steuerungen im Transformator und in der Kurzschlusstesteinheit zurückgreifen.

In einer bevorzugten Weiterbildung besitzt die Kurzschlusstesteinheit einen Schalter, mit dem die Serienimpedanz überbrückt werden kann.

Bevorzugt arbeitet der Transformator auf Mittelspannungsebene, das bedeutet, die Spannung wird von Mittelspannungsebene zu Mittelspannungsebene transformiert.

Ein Beispiel der Erfindung wird nachfolgend näher erläutert. Es zeigen:
- Fig. 1: einen schematischen Aufbau der Prüfeinrichtung,
- Fig. 2: den zeitlichen Verlauf der Spannung bei einer HVTR-Prüfung,
- Fig. 3: einen alternativen Verlauf von der Spannung bei einer HVTR-Prüfung und
- Fig. 4: eine alternative Ausgestaltung einer Prüfeinrichtung.

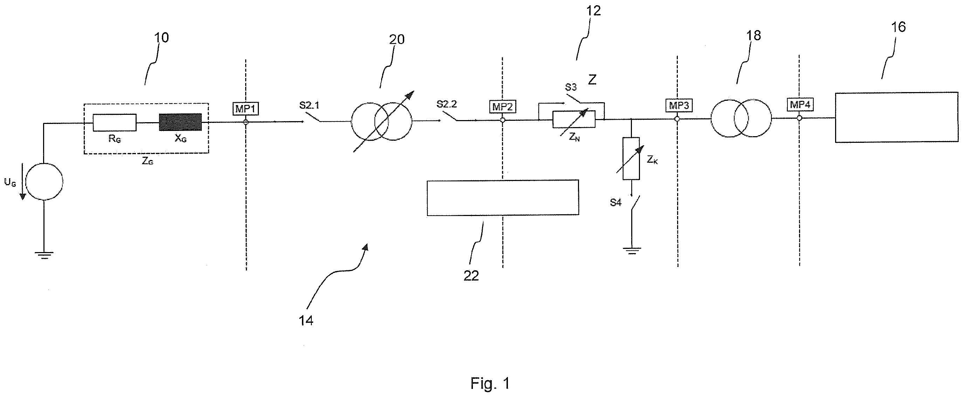

Der Aufbau der erfindungsgemäßen Prüfeinrichtung 14 ist in Fig. 1 dargestellt. Zwischen den Messpunkten MP2 und MP3 befindet sich eine Kurzschlusstesteinrichtung 12 mit einer Impedanz Z zum Erzeugen von transienten Unterspannungen. Diese ist zwischen eine Windenergieanlage 16 und ein elektrisches Versorgungsnetz 10 geschaltet. Die Kurzschlusstesteinheit 12 besitzt eine Serien- und eine Längsimpedanz Z_{N} und Z_{K}, die geschaltet werden, um die Spannung der Windenergieanlage für eine definierte Dauer um einen definierten Betrag zu reduzieren. Die Serienimpedanz Z_{N} kann durch einen Schalter S3 überbrückt werden. Die Längsimpedanz Z_{K} kann durch einen Schalter S4 geerdet werden.

Zusätzlich ist bei der erfindungsgemäßen Vorrichtung ein schaltbarer Transformator 20 zwischen die Messpunkte MP1 und MP2 geschaltet. Der schaltbare Transformator 20 arbeitet auf Mittelspannungsebene und kann als ein Trenntransformator oder ein Spartransformator ausgeführt sein, wobei Trenntransformatoren in der Regel von den Netzbetreibern bevorzugt werden. Der schaltbare Transformator 20 besitzt verschiedene Wicklungsabgriffe, um die Spannung an der Kurzschlusstesteinheit 12 einstellbar zu reduzieren bzw. zu erhöhen. Die Anzahl der Wicklungsabgriffe bestimmt die Einstellgenauigkeit der Spannung im Messpunkt MP2. Die Stufbarkeit in ca. 2% U_{N} von der Nennspannung kann hier gut realisiert werden. Vorzugsweise beträgt der einstellbare Spannungsbereich im Punkt MP2 mindestens -20% bis +30% der Nennspannung U_{N} und ist durch -10 und +15 Stufen realisiert. Die Abgriffe des schaltbaren Transformators können beispielsweise durch einen Vakuumschalter unter Last und Spannung geschaltet werden. Hierzu kann das Schalten beispielsweise über eine Fernsteuerung erfolgen. Da ein Einschalten unter Last und Spannung erfolgen kann, wird eine Trennung des Transformators während des Tests zur Einstellung eines neuen Übersetzungsverhältnisses vermieden und verringert hierdurch die Dauer der Prüfung. Ein weiterer Vorteil liegt darin, dass die Stromerzeugungseinheit weiterhin im Produktionsbetrieb verbleiben kann.

Die Stufung des schaltbaren Transformators 20 kann in allen drei Phasen der Drehstromleitung gleichzeitig durchgeführt werden. Bevorzugt wird allerdings eine Stufung, die für jede Phase unabhängig gewählt werden kann. Durch diese asymmetrische Stufung des Transformators können dann auch asymmetrische Spannungen an dem Messpunkt MP3 erzeugt werden.

Die Ansteuerung kann in einer gesonderten Steuereinrichtung 22 ausgeführt werden, die auf geeignete Weise mit den einzelnen schalt- bzw. steuerbaren Komponenten der Kurzschlusstesteinheit 12 verbunden ist. In einer bevorzugten Ausgestaltung sind die Steuerungen (nicht dargestellt) der Kurzschlusstesteinheit 12 und des schaltbaren Transformators 20 miteinander verbunden, sodass ein abgestimmtes Durchlaufen des Verfahrens erfolgen kann. In einer besonders bevorzugten Ausgestaltung sind die Steuerungen von Kurzschlusstesteinheit und Transformator in der Steuereinrichtung 22 baulich vereinigt. In einer weiteren bevorzugten Ausgestaltung ist wenigstens eine der Steuerungen und/oder die Steuereinrichtung 22 eingerichtet, Messdaten zu speichern. Die Messdaten können über einen oder mehrere Messvorrichtungen (nicht dargestellt) erfasst werden, welche beispielsweise an den Messpunkten MP1 - MP4 vorgesehen sein können. Die Messvorrichtungen sind dazu in geeigneter Weise mit der wenigstens einen Steuereinheit kommunikativ verbunden.

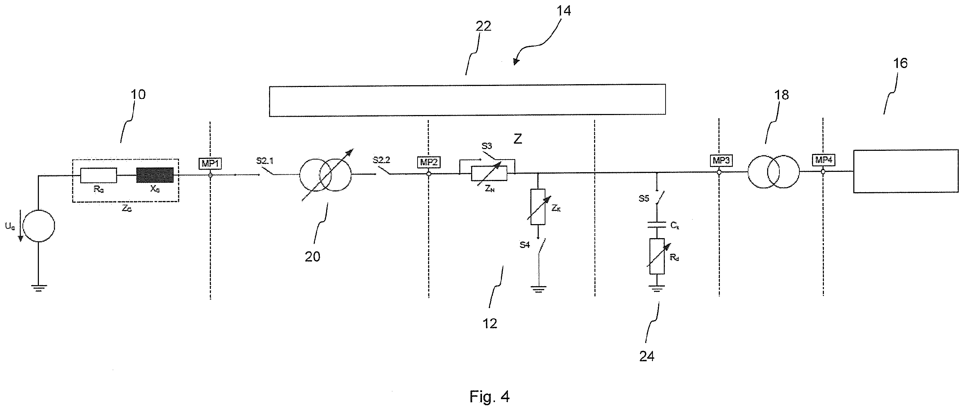

Die in Figur 4 dargestellte Variante unterscheidet sich von der Variante aus Figur 1 lediglich dahingehend, dass zusätzlich eine Überspannungstesteinheit 24 mit einem Kondensator Cₖ vorgesehen ist, die ein zusätzliches Hochsetzen der Spannung in Messpunkt MP3 erlaubt. Mittels des Schalters S5 kann der Kondensator Cₖ im regulären Betrieb geladen und zum Hochsetzen der Spannung entladen werden. Auch die Überspannungstesteinheit 24 wird von der Steuereinrichtung 22 angesteuert.

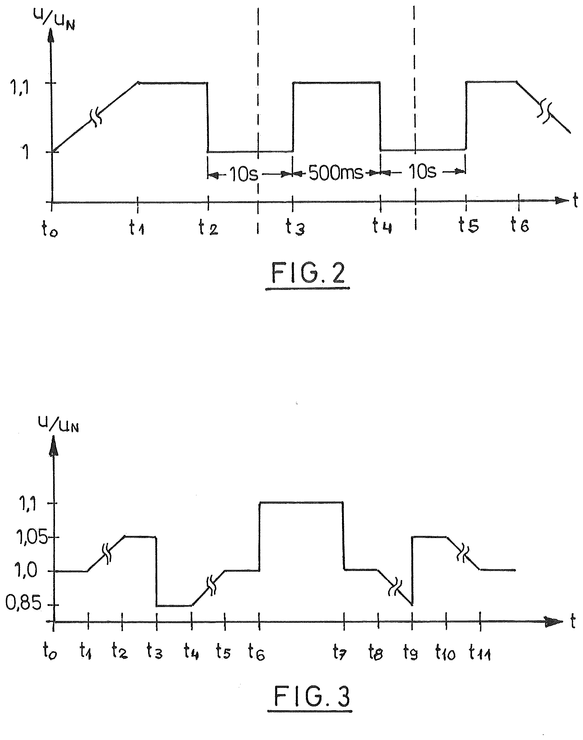

Der Spannungssprung für die Prüfung an der Windenergieanlage wird gemäß dem zeitlichen Verlauf aus Fig. 2 erzeugt. Zum Zeitpunkt t₀ wird die Windenergieanlage bei einer Netzspannung von 1 p.u. betrieben. Das Übersetzungsverhältnis des Transformators ist dazu zu 1 : 1 gewählt. Die Kurzschlusstesteinheit ist nicht aktiv. Anschließend wird der Transformator dazu genutzt, um langsam die Spannung auf 1,1 p.u. zu erhöhen. Zum Zeitpunkt t₁ ist der Spannungswert 1,1 p.u. an der Windenergieanlage erreicht. Die Dauer und Dynamik ist hier nicht entscheidend. Typischer Weise kann die Spannungserhöhung 1 bis 3 Minuten dauern, wobei die Windenergieanlage während der Verstellung der Spannung über den Transformator im Produktionsbetrieb verbleibt. Weder eine Trennung der Windenergieanlage, noch eine Trennung des Transformators über einen Bypassschalter sind notwendig, um den HVRT-Fall zu prüfen.

Zum Zeitpunkt t₂ wird die Spannung durch Schalten einer geeigneten Längs- und Kurzschlussimpedanz der Kurzschlusstesteinheit um 0,1 p.u. verringert. Die Spannung wird innerhalb von 20 ms auf den neuen Wert springen. Dies wird ein transientes Einschwingverhalten der Windenergieanlage verursachen. Nach Abklingen der transienten Vorgänge, ca. 0,5 s, beginnt der Zeitraum der später für die Prüfung ausgewertet wird. Zum Zeitpunkt t₃ wird die Längs- und Kurzschlussimpedanz der Kurzschlusstesteinheit wieder ausgeschaltet. Die Spannung an der Windenergieanlage springt zurück auf die Ausgangsspannung des Transformators, die ungefähr 110% U_{N} beträgt.

Nach einer variablen Zeitdauer zum Beispiel von 500 ms, wird die Spannung zum Zeitpunkt t₄ an der Windenergieanlage durch Schalten der Kurzschlusstesteinheit wieder sprunghaft für weniger als 20 ms auf 100% U_{N} verringert. Nach Abklingen des transienten Verhaltens der Windenergieanlage (ca. 5 bis 10 Sekunden) ist eine HVRT-Messung abgelaufen. Im Folgenden wird die Spannung an der Windenergieanlage wieder zum Nennbetrieb zurückgeführt und die Kurzschlusstesteinheit ausgeschaltet. Die Spannung an der Windenergieanlage springt auf 110% U_{N}, die Kurzschlusstesteinheit ist nicht mehr aktiv.

Ab dem Zeitpunkt t₆ wird die Spannung an der Kurzschlusstesteinheit und an der Windenergieanlage durch Stufung des Transformators wieder langsam über eine Zeitspanne von 1 bis 3 Minuten auf Nennspannung zurückgeführt. Die Serienimpedanz der Kurzschlusstesteinheit wird zum Zeitpunkt t₁ und zum Zeitpunkt t₅ ausgeschaltet. Sie dient technisch der Verringerung der Netzrückwirkungen.

Um die quasi stationäre Belastung der Windenergieanlage vor und nach dem Spannungssprung zu verringern, kann das Verfahren so angepasst werden, dass das Hoch- und Runterfahren der Spannung durch den Transformator in zwei Stufen aufgeteilt wird. Der resultierende Spannungsverlauf an der Windenergieanlage ist beispielhaft in Figur 3 skizziert.

Der in Figur 3 dargestellte zeitliche Verlauf beginnt zum Zeitpunkt t₀, bei dem die Kurzschlusstesteinheit ausgeschaltet ist und der Transformator ein gleiches Übersetzungsverhältnis von ungefähr 1 : 1 besitzt. Zum Zeitpunkt t₁ erhöht der Transformator die Spannung auf 105% U_{N}, bis dieser Wert zum Zeitpunkt t₂ erreicht ist. Zum Zeitpunkt t₃ vermindert die Kurzschlusstesteinheit die Spannung dynamisch um 10% auf 0,95 U_{N} der Windenergieanlage. Beginnend im Zeitpunkt t₄, erhöht der Transformator die Spannung um weitere 5% bis zum Zeitpunkt t₅ wieder U_{N}, also 100% der Windenergieanlage erreicht sind. Zum Zeitpunkt t₆ wird die Kurzschlusstesteinheit ausgeschaltet und die Spannung springt auf 110% U_{N} der Windenergieanlage. Unterstützend kann hierbei die Überspannungstesteinheit 24 über ihren Schalter S5 zugeschaltet werden. Die erhöhte Spannung wird über einen vorgegebenen Mindestzeitraum gehalten, bis die Kurzschlusstesteinheit wieder eingeschaltet wird und die Spannung auf 100% der Windenergieanlage herunterspringt. Zum Zeitpunkt t₈ ist die HVRT-Prüfung beendet. Der Transformator beginnt die Spannung um -5% U_{N} zu stufen. Zum Zeitpunkt t₉ sind 95% U_{N} an der Windenergieanlage erreicht. Durch Ausschalten der Kurzschlusstesteinheit springt die Spannung noch einmal um 10% auf einen Wert von 105 % U_{N}. Zum Zeitpunkt t₁₀ verringert der Transformator die Spannung um weitere -5% U_{N}, bis zum Zeitpunkt t₁₁ der Ausgangspunkt wieder erreicht ist. Die Kurzschlusstesteinheit ist ausgeschaltet und der Transformator besitzt wieder ein gleiches Übersetzungsverhältnis von 1 : 1.

Auch bei dem in Figur 3 dargestellten zeitlichen Verlauf wird in der Kurzschlusstesteinheit die Serienimpedanz vor Einsatz der Längsdrossel ein- und nach Deaktivierung der Längsdrossel ausgeschaltet. Dies bedeutet, dass zum Zeitpunkt t₂ die Seriendrossel in Figur 3 ein- und zum Zeitpunkt t₁₀ ausgeschaltet wird.

Fig. 4 zeigt zusätzlich eine zwischen die Kurzschlusstesteinheit Z und die Windenergieanlage im Punkt MP3 gesetzte Überspannungstesteinheit. Die Überspannungstesteinheit besteht aus einem in einer Stichleitung zuschaltbaren Kondensator mit einem Ohm'schen Widerstand. Durch ein Zuschalten der Überspannungstesteinheit kann mit dem Entladen des Kondensators die Spannung weiter erhöht werden.

Die Erzeugung der erforderlichen Spannungssprünge benötigt lediglich zusätzlich einen auf Mittelspannungsebene arbeitenden Transformator, der beispielsweise mit einem on load tap changer unter Spannung und Last geschaltet werden kann. Ferner erlaubt das Verstellen der Spannung über den Transformator den Produktionsbetrieb fortzusetzen.

### Bezugszeichenliste:

- 10: elektrisches Versorgungsnetz (Ersatzschaltbild)
- 12: Kurzschlusstesteinheit
- 14: Prüfvorrichtung
- 16: Windenergieanlage
- 18: Transformator der Windenergieanlage
- 20: schaltbarer Transformator
- 22: Steuereinrichtung
- 24: Überspannungstesteinheit

## Patentansprüche

1. Verfahren zur Prüfung einer Stromerzeugungseinheit, insbesondere einer Windenergieanlage, die mit einem elektrischen Versorgungsnetz verbunden ist, das folgende Schritte aufweist:
- Erhöhen einer Spannung an der Stromerzeugungseinheit mittels eines unter Last schaltbaren Transformators,
- Einschalten einer Kurzschlusstesteinheit mit einer Serienimpedanz und einer Längsimpedanz, um die erhöhte Spannung zu verringern,
- Ausschalten der Kurzschlusstesteinheit für eine definierte erste Zeitspanne , nachdem transiente Einschaltvorgänge abgeklungen sind, und,
- nach Ablauf der ersten Zeitspanne, Einschalten der Kurzschlusstesteinheit für eine definierte zweite Zeitspanne, um die erhöhte Spannung herabzusetzen.

2. Verfahren nach Anspruch 1 **dadurch gekennzeichnet, dass** mindestens in der ersten und der zweiten definierten Zeitspanne mindestens eine elektrische Größe der Stromerzeugungseinheit gemessen wird.

3. Verfahren nach Anspruch 1 oder 2, **dadurch gekennzeichnet, dass** nach Ablauf der zweiten definierten Zeitspanne die Spannung herabgesetzt wird, indem ein gleiches Übersetzungsverhältnis von bevorzugt 1:1 an dem unter Last schaltbaren Transformator eingestellt wird.

4. Verfahren nach Anspruch 3, **dadurch gekennzeichnet, dass** nach Ablauf der zweiten definierten Zeitspanne die Kurzschlusstesteinheit ausgeschaltet wird.

5. Verfahren nach einem der Ansprüche 1 bis 4 **dadurch gekennzeichnet, dass** die Kurzschlusstesteinheit die hochgesetzte Spannung auf einen an dem Transformator anliegenden Spannungswert herabsetzt.

6. Verfahren nach einem der Ansprüche 1 bis 4 **dadurch gekennzeichnet, dass** die Kurzschlusstesteinheit den Spannungswert auf einen Wert herabsetzt, der kleiner als der an dem Transformator anliegende Spannungswert ist.

7. Verfahren nach Anspruch 6, **dadurch gekennzeichnet, dass** die mittels des unter Last schaltbaren Transformators erhöhte Spannung auf einen Wert hochgesetzt wird, der bei zugeschalteter Kurzschlusstesteinheit dem Wert der an dem Transformator anliegenden Spannung entspricht.

8. Verfahren nach einem der Ansprüche 1 bis 7, **dadurch gekennzeichnet, dass** die Stromerzeugungseinheit während der Durchführung des Prüfverfahrens mit dem Versorgungsnetz verbunden bleibt.

9. Verfahren nach einem der Ansprüche 1 bis 8, **dadurch gekennzeichnet, dass** die Spannung mittels eines zuschaltbaren Kondensators einer Überspannungstesteinheit durch eine Entladung des Kondensators weiter erhöht wird.

10. Vorrichtung zur Prüfung einer mit einem elektrischen Versorgungsnetz (10) verbundenen Stromerzeugungseinheit, insbesondere einer Windenergieanlage (16), die eine zwischen Stromerzeugungseinheit und Versorgungsnetz (10) schaltbare Kurzschlusstesteinheit (12) mit einer Längsimpedanz (Zₖ) und einer Serienimpedanz (Z_{N}) und einen zwischen Kurzschlusstesteinheit (12) und Versorgungsnetz (10) schaltbaren Transformator (20) aufweist, der unter Last stufbar ist und der mit allen Strängen einer Drehstromleitung verbunden ist, wobei die Stufung des schaltbaren Transformators (20) in jeder Phase unabhängig wählbar ist.

11. Vorrichtung nach Anspruch 10, **dadurch gekennzeichnet, dass** eine Steuereinrichtung (22) vorgesehen ist, die den schaltbaren Transformator (20) und die Kurzschlusstesteinheit (12) ansteuert.

12. Vorrichtung nach Anspruch 11, **dadurch gekennzeichnet, dass** die Steuereinrichtung (22) eingerichtet ist, ein Verfahren nach einem der Ansprüche 1 bis 9 auszuführen.

13. Vorrichtung nach einem der Ansprüche 10 bis 12, **dadurch gekennzeichnet, dass** die Serienimpedanz (Z_{N}) der Kurzschlusstesteinheit (12) einen Überbrückungsschalter (S3) aufweist.

14. Vorrichtung nach einem der Ansprüche 10 bis 13, **dadurch gekennzeichnet, dass** der schaltbare Transformator (20) als Mittelspannungstransformator ausgebildet ist.

15. Vorrichtung nach einem der Ansprüche 10 bis 14, **dadurch gekennzeichnet, dass** zwischen Kurzschlusstesteinheit (12) und Stromerzeugungseinheit (16) eine mit einem Kondensator (Cₖ) versehene, zuschaltbare Überspannungstesteinheit (24) vorgesehen ist, die zugeschaltet durch Entladen des Kondensators (Cₖ) die Spannung an der Stromerzeugungseinheit erhöht.

## Claims

1. Method for testing a power generating device, in particular a wind turbine, which is connected to an electrical supply network comprising the following steps:
- increasing a voltage at the power generating device by means of a transformer which is switchable under load,
- switching on a short-circuit test unit having a series impedance and a longitudinal impedance to reduce the increased voltage,
- switching off the short-circuit test unit for a defined first period of time after transient switch-on processes have decayed, and
- after the first time period has elapsed, switching on the short-circuit test unit for a defined second time period in order to reduce the increased voltage.

2. Method according to claim 1, **characterized in that** at least one electrical indicator of the power generating device is measured at least in the defined first and second time period.

3. Method according to claim 1 or 2, **characterized in that** the voltage is reduced after elapse of the defined second period of time by setting an equal transmission ratio of preferably 1:1 at the transformer which is switchable under load.

4. Method according to claim 3, **characterized in that** the short-circuit test unit is switched off after elapse of the defined second time period.

5. Method according to any of claims 1 to 4, **characterized in that** the short-circuit test unit reduces the raised voltage to a voltage value applied to the transformer.

6. Method according to any one of claims 1 to 4, **characterized in that** the short-circuit test unit reduces the voltage value to a value lower than the voltage value applied to the transformer.

7. Method according to claim 6, **characterized in that** the voltage increased by means of the transformer which is switchable under load is raised to a value which, when the short-circuit test unit is switched on, corresponds to the value of the voltage applied to the transformer.

8. Method according to any of claims 1 to 7, **characterized in that** the power generating device remains connected to the supply network during performance of the test process.

9. Method according to one of claims 1 to 8, **characterized in that** the voltage is further increased by discharging of a capacitor of an overvoltage test unit by means of a switchable capacitor.

10. Device for testing a power generating device connected to an electrical supply network (10), in particular a wind turbine (16), which has a short-circuit test unit (12) which can be connected between the power generating device and the supply network (10) and has a longitudinal impedance (Zₖ) and a series impedance (Z_{N}) and a transformer (20) which can be connected between the short-circuit test unit (12) and the supply network (10) and can be scaled under load and which is connected to all strands of a three-phase current line, the pitch of the switchable transformer (20) being independently selectable in each phase.

11. Device according to claim 10, **characterized in that** a control device (22) is provided which controls the switchable transformer (20) and the short-circuit test unit (12).

12. Device according to claim 11, **characterized in that** the control device (22) is equipped to execute a method according to one of claims 1 to 9.

13. Device according to any of claims 10 to 12, **characterized in that** the series impedance (Z_{N}) of the short-circuit test unit (12) comprises a bypass switch (S3).

14. Device according to any one of claims 10 to 13, **characterized in that** the switchable transformer (20) is designed as a medium-voltage transformer.

15. Device according to any one of claims 10 to 14, **characterized in that** a switchable overvoltage test unit (24) which is provided with a capacitor (Cₖ) and can be switched on is provided between the short-circuit test unit (12) and the power generating device (16), which overvoltage test unit (24) when switched on increases the voltage at the power generating device by discharging the capacitor (Cₖ).

## Revendications

1. Procédé destiné à vérifier une unité de production de courant, en particulier une éolienne, reliée à un réseau d'alimentation électrique, qui présente les étapes suivantes :
- l'accroissement d'une tension sur l'unité de production de courant moyennant un transformateur commutable sous charge,
- la mise en marche d'une unité de test de court-circuit dotée d'une impédance en série et d'une impédance longitudinale pour réduire la tension accrue,
- l'arrêt de l'unité de test de court-circuit durant une première période définie, après que les processus transitoires de mise sous tension se sont estompés, et
- la mise en marche de l'unité de test de court-circuit pendant une seconde période définie pour faire baisser la tension accrue, une fois la première période écoulée.

2. Procédé selon la revendication 1, **caractérisé en ce qu'**au moins une grandeur électrique de l'unité de production de courant est mesurée au moins au cours de la première et de la seconde période définie.

3. Procédé selon la revendication 1 ou 2, **caractérisé en ce que** la tension est diminuée une fois la seconde période définie écoulée, tandis qu'un même rapport de transformation de préférence de 1:1 est réglé sur le transformateur commutable sous charge.

4. Procédé selon la revendication 3, **caractérisé en ce que** l'unité de test de court-circuit est arrêtée, une fois la seconde période définie écoulée.

5. Procédé selon l'une des revendications 1 à 4, **caractérisé en ce que** l'unité de test de court-circuit fait baisser la tension augmentée sur une valeur de tension appliquée au transformateur.

6. Procédé selon l'une des revendications 1 à 4, **caractérisé en ce que** l'unité de test de court-circuit fait baisser la tension sur une valeur, qui est plus petite que la valeur de tension appliquée au transformateur.

7. Procédé selon la revendication 6, **caractérisé en ce que** la tension accrue moyennant le transformateur commutable sous charge est augmentée à une valeur qui correspond à la valeur de la tension appliquée au transformateur lorsque l'unité de test de court-circuit est activée.

8. Procédé selon l'une des revendications 1 à 7, **caractérisé en ce que** l'unité de production de courant reste reliée au réseau d'alimentation durant l'exécution du procédé de vérification.

9. Procédé selon l'une des revendications 1 à 8, **caractérisé en ce que** la tension est encore accrue moyennant un condensateur activable d'une unité de test de surtension par une décharge du condensateur.

10. Dispositif destiné à vérifier une unité de production de courant reliée à un réseau d'alimentation électrique (10), en particulier une éolienne (16), qui présente une unité de test de court-circuit (12) commutable entre l'unité de production de courant et le réseau d'alimentation (10) avec une impédance longitudinale (Zₖ) et une impédance en série (Z_{N}) ainsi qu'un transformateur (20) commutable entre l'unité de test de court-circuit (12) et le réseau d'alimentation (10), qui est variable par paliers sous charge et relié à tous les conducteurs d'une ligne à courant alternatif, dans lequel la plage de variation du transformateur (20) commutable peut être sélectionnée indépendamment à chaque phase.

11. Dispositif selon la revendication 10, **caractérisé en ce qu'**un système de commande (22) est prévu, qui active le transformateur (20) commutable et l'unité de test de court-circuit (12).

12. Dispositif selon la revendication 11, **caractérisé en ce que** le système de commande (22) est ajusté pour exécuter un procédé selon l'une des revendications 1 à 9.

13. Dispositif selon l'une des revendications 10 à 12, **caractérisé en ce que** l'impédance en série (Z_{N}) de l'unité de test de court-circuit (12) présente un contacteur de pontage (S3).

14. Dispositif selon l'une des revendications 10 à 13, **caractérisé en ce que** le transformateur (20) commutable constitue un transformateur de moyenne tension.

15. Dispositif selon l'une des revendications 10 à 14, **caractérisé en ce qu'**une unité de test de surtension (24) commutable, pourvue d'un condensateur (Cₖ) est prévue entre l'unité de test de court-circuit (12) et l'unité de production de courant (16), qui étant activée accroît la tension sur l'unité de production de courant par la décharge du condensateur (Ck).
